# EUROPÄISCHE PATENTSCHRIFT

(11) **EP 3 564 036 B1**
(45) Veröffentlichungstag und Bekanntmachung des Hinweises auf die Patenterteilung: **07.07.2021**
(21) Anmeldenummer: 18170503.9
(22) Anmeldetag: 03.05.2018
(51) Int. Cl.: B41C 1/00, B41C 1/10, B41F 27/00

(54) **AUTOMATISCHE DRUCKPLATTENSORTIERUNG**
AUTOMATIC PRINTING PLATE SORTING
TRI AUTOMATIQUE DE PLAQUES D'IMPRESSION

(43) Veröffentlichungstag der Anmeldung: 06.11.2019
(73) Patentinhaber: Heidelberger Druckmaschinen AG, 69115 Heidelberg (DE)
(72) Erfinder: von Spreckelsen, Meino, 24105 Kiel (DE); Bauch, Sebastian, 24118 Kiel (DE)

(56) Entgegenhaltungen:
- EP-A2- 2 420 384
- WO-A1-2010/081569

## Beschreibung

Die vorliegende Erfindung betrifft ein Verfahren zur sortierten Herstellung und Logistik von Druckplatten für eine Offsetdruckmaschine.

Die Erfindung liegt im technischen Gebiet des Offsetdrucks.

Die zunehmende Automatisierung der Prozesse in einer Offset-Druckerei rückt auch die Druckplattenausgabe mehr in den Fokus. Es werden zunehmend Druckplattenbelichter mit automatischem Platteneinzug, Entwicklung und Ablage auf einem Plattenwagen eingesetzt. Ein Problem stellt dabei jedoch die Sortierung der erzeugten Druckplatten auf dem Plattenwagen dar. Der Drucker muss schließlich zum Rüsten und Einstellen der Druckmaschine die Druckplatten in einer bestimmten Reihenfolge in der Druckmaschine anbringen. Diese Reihenfolge ist unter Anderem von den zum Rüsten der Druckmaschine notwendigen Arbeitsgänge abhängig. Diese Arbeitsgänge umfassen vor allem:
- Wie erwähnt das Rüsten der Maschine mit den für den Bogen benötigten Druckplatten (bei doppelseitigem 4-Farbdruck: 8)
- Das Einrichten der Maschine für den Fortdruck ("in Farbe kommen"), inkl. Drucken der dafür nötigen Makulaturbögen
- Den Gut-/Fortdruck der geforderten Druckauflage

Diese Druckarbeitsgänge werden in einer durchorganisierten Druckerei pro Druckmaschine mit Start- und Ende-Zeit geplant, so dass die Druckmaschine möglichst lückenlos drucken kann. Die Herstellung der Druckplatten orientiert sich dann nach diesen Planzeiten, um die für die Arbeitsgänge benötigten Platten in der erforderlichen Reihenfolge bereitzustellen.

Derzeit werden zudem als letzte Schritte in der Druckvorstufe, die digital fertigen Druckbogenseparationen "gerendert" - d.h. gerasterte Bitmaps gerechnet und dies entweder direkt auf einem CtP-Belichter ausgegeben oder in einer Datei, meist im Tiff-B-Format, zwischengespeichert. Bei Zwischenablage in Tiff-B-Dateien können diese dann anschließend manuell in der gewünschten Reihenfolge zum Belichter geschickt werden. Für die automatische Plattenverarbeitung nach dem Belichten sind im Stand der Technik dann mehrere Lösungen bekannt.

Eine dieser Lösungen wird in der US-Patentanmeldung US 2007 186 795 A1 in Form eines Verfahrens zur automatisierten Druckplattenherstellung offenbart.

Die japanische Patentanmeldung JP 2010 049 156 A wiederum zeigt ein Verfahren und eine Vorrichtung zur lithografischen Druckplattenherstellung in welcher die hergestellten Druckplatten markiert und sortiert werden.

Weiterer bekannter Stand der Technik ist die deutsche Patentanmeldung DE 10 2008 002 679 A1. Hier handelt es sich m.E. um ein System, dass in der Druckmaschine integriert ist und an Hand von auf den Druckplatten aufgebrachten Bar- oder DataMatrix-Codes die Platten identifiziert. So stellt das System sicher, dass die für einen mehrfarbigen Druck vorgesehenen Platten in der Maschine eingespannt sind. Eine Steuerung der Plattenausgabe ist jedoch nicht vorgesehen.

Zudem ist aus der europäischen Patentanmeldung EP 2 420 384 A2 eine Druckmaschinenanlage mit wenigstens einer Druckeinheit bekannt; einer Mehrzahl von Betriebssystemen, die ein Druckvorstufensystem zur Erstellung von Druckformdaten, ein Druckformbearbeitungssystem zur Herstellung und Bearbeitung von Druckformen auf Basis der Druckformdaten, ein Druckformladesystem zum Laden der Druckformen in Transportaufnahmen, ein Transportsystem zum Transportieren der Transportaufnahmen zu der wenigstens einen Druckeinheit und ein Druckformzuführsystem zum Entladen der Druckformen aus den Transportaufnahmen und Laden der Druckformen in die wenigstens eine Druckeinheit aufweisen; einer Steuerung, die zum Steuern dieser mit den Betriebssystemen verbunden ist; und wenigstens einer Anzeigevorrichtung, die mit der Steuerung verbunden ist, so dass von der Steuerung ausgegebene Daten auf der Anzeigevorrichtung anzeigbar sind, wobei die Steuerung eingerichtet ist, übergreifend über alle Betriebssysteme Statusdaten für jede Druckform zu ermitteln und die Statusdaten jeder Druckform zum Anzeigen an die Anzeigevorrichtung auszugeben, womit eine gesamtheitliche Überwachung der die Druckformen betreffenden Arbeitsabläufe gewährleistet ist.

Zudem ist von der Firma Nela in Zusammenarbeit mit der Druckerei Sandler eine Druckplattenautomation bekannt. Diese beinhaltet den Einsatz einer Plattensortierung. Das Nela-System identifiziert Druckplatten an Hand von auf den Druckplatten aufgebrachten Bar- oder Data-Matrix-Codes und ordnet sie darüber z.B. einer bestimmten Druckmaschinen zu. Eine Steuerung der Reihenfolge der Plattenausgabe erfolgt hier nicht, sondern es wird lediglich dafür gesorgt, dass die für eine Maschine vorgesehenen Platten auf einem Plattenwagen ausgegeben werden.

Keines dieser Dokumente zeigt daher ein Verfahren für die auftragsübergreifende Vorsortierung der Plattenausgabe nach dem Drucktermin. Die derzeit bekannten Ausgabemethoden beinhalten lediglich eine Ausgabe nach Auftragsweise; d.h. je nach Anzahl der Bögen pro Auftrag. Dies führt zur Notwendigkeit vieler Druckplattenwagen und ermöglicht keine auftragsübergreifende Optimierung der Druckreihenfolge. Zudem ist eine manuelle Sortierung nach Planlisten für die Druckmaschine bekannt. Diese ist jedoch sehr arbeitsintensiv und fehlerträchtig. So müssen z.B. belichtete Platten mit dem Risiko einer Beschädigung im Plattenwagen umsortiert und gesucht werden.

Die Aufgabe der vorliegenden Erfindung besteht somit darin, ein Verfahren zur möglichst effizienten Logistik von Offsetdruckplatten zu finden, welches den Drucker bei der schnellstmöglichen Bewältigung notwendiger Rüstvorgänge an Offsetdruckmaschinen unterstützt.

Gelöst wird diese Aufgabe durch ein Verfahren zur Herstellung von belichteten Druckplatten für einen Druckprozess von Offsetdruckmaschinen durch einen Rechner eines Workflowsystems, wobei der Rechner in der Druckvorstufe Druckauftragsdaten sammelt, daraus dann einen Satz digitaler Farbauszugsdaten zur Erstellung der Druckplatten generiert, diese an mindestens einen Plattenbelichter schickt, wo die betreffenden, belichteten Druckplatten erzeugt werden, von wo sie dann als mindestens ein Druckplattenstapel mittels mindestens eines Plattenwagens zu ihren jeweiligen Offsetdruckmaschinen transportiert werden und wobei die Offsetdruckmaschinen dann mit den erzeugten belichteten Druckplatten den Druckprozess durchführt, wobei der Rechner den Satz digitaler Farbauszugsdaten zur Erstellung der Druckplatten in einer Reihenfolge abhängig von der geplanten Reihenfolge notwendiger Arbeitsgänge an den Offsetdruckmaschinen sortiert, wodurch der mindestens eine Druckplattenstapel der daraus erzeugten, belichteten Druckplatten dann auf dem mindestens einen Plattenwagen in der jeweils benötigten Reihenfolge zu den Offsetdruckmaschinen transportiert werden. Dem erfindungsgemäßen Verfahren zur Herstellung von Druckplatten liegt die Erkenntnis zugrunde, dass für eine möglichst effiziente, d.h. schnelle Rüstung der Maschine, eine möglichst schnelle Abarbeitung der einzelnen notwendigen Arbeitsgänge erfolgen muss. Um welche notwendigen Arbeitsgänge es sich dabei handelt, ist dem System bekannt. Aus diesem Wissen lässt sich die Reihenfolge der entsprechend notwendigen Arbeitsgänge bestimmen. Abhängig von dieser Reihenfolge der notwendigen Arbeitsgänge lassen sich dann die digitalen Farbauszugsdaten zur Erstellung der

Druckplatten in eine entsprechende Reihenfolge bringen, wodurch die daraus erzeugten und belichteten Druckplatten in einer bestimmten Reihenfolge im Druckplattenstapel auf dem Plattenwagen abgelegt werden. Auf dem Plattenwagen werden die dergestalt sortierten Druckplatten dann in der so bestimmten Reihenfolge zu den Offsetdruckmaschinen transportiert. Dies ermöglicht dem Drucker die bestmögliche Abarbeitung der notwendigen Arbeitsgänge, da die Druckplatten bereits in der entsprechenden korrekten Reihenfolge für die bestmöglich effiziente Abarbeitung der Arbeitsgänge zur Verfügung gestellt werden. Vorteilhafte und daher bevorzugte Weiterbildungen des Verfahrens ergeben sich aus den zugehörigen Unteransprüchen sowie aus der Beschreibung mit den zugehörigen Zeichnungen.

Eine bevorzugte Weiterbildung des erfindungsgemäßen Verfahrens ist dabei, dass die notwendigen Arbeitsgänge an den Offsetdruckmaschinen den Rüstvorgängen der Druckplatten der jeweiligen Farbauszüge an der Offsetdruckmaschine, sowie dem Einrichten der Offsetdruckmaschine für den Fortdruck inkl. des Druckens der dafür nötigen Makulaturbögen und dem Fortdruck zur Abarbeitung des Druckprozesses entsprechen. Die notwendigen Arbeitsgänge sind logischerweise direkt mit dem Einsatz der erzeugten Druckplatten verknüpft. Arbeitsgänge, wie das Einspannen der Druckplatten der jeweiligen Farbauszüge in der Maschine sowie das Einrichten der Offsetdruckmaschine für den Vordruck etc., lassen sich durch die entsprechende Vorsortierung gemäß des erfindungsgemäßen Verfahrens äußerst effizient durchführen.

Eine weitere bevorzugte Weiterbildung des erfindungsgemäßen Verfahrens ist dabei, dass die notwendigen Arbeitsgänge vom Rechner jeweils für eine bestimmte Offsetdruckmaschine vom Rechner nach ihrem geplanten Startdatum sortiert werden. Da der Kernpunkt des erfindungsgemäßen Verfahrens darin besteht, jeder Druckmaschine die den Druckauftragsdaten für diese Offsetdruckmaschine repräsentierenden vorsortierten Druckplatten zur Verfügung zu stellen, muss hierfür natürlich der Rechner den Satz digitaler Farbauszugsdaten, aus denen die entsprechenden Druckplatten erstellt werden, auch gemäß der entsprechenden Offsetdruckmaschine, an der diese Druckplatten dann verwendet werden sollen, kopiert werden. Das entsprechende Sortierkriterium ist dabei das geplante Startdatum für die geplanten Arbeitsgänge an der Offsetdruckmaschine.

Eine weitere bevorzugte Weiterbildung des erfindungsgemäßen Verfahrens ist dabei, dass die sortierten Arbeitsgänge durch den Rechner in Gruppen, deren belichtete Druckplatten jeweils auf einem Plattenwagen transportiert werden sollen, zusammengefasst werden. Die Gruppierung ist dabei, wie bereits erläutert, abhängig von der jeweiligen Druckmaschine, für die der entsprechende Satz von belichteten Druckplatten erstellt wurde. Jeder Satz wird üblicherweise auf einem Plattenwagen transportiert, so dass jeder Plattenwagen einer bestimmten Druckmaschine zugeordnet werden kann, was in der Konsequenz zu einer Gruppierung nicht nur abhängig von der Zieldruckmaschine, sondern auch abhängig von dem jeweiligen Plattenwagen, der zu dieser Zieldruckmaschine transportiert, macht.

Eine weitere bevorzugte Weiterbildung des erfindungsgemäßen Verfahrens ist dabei, dass die Ausgabereihenfolge der Arbeitsgänge pro Druckplattenstapel in der geplanten oder umgekehrt zur geplanten Druckreihenfolge erfolgt. Welche Reihenfolge, ob geplant oder umgekehrt zur geplanten Druckreihenfolge, bleibt dem Anwender überlassen. Üblicherweise sollte diese Abstimmung von dem Drucker und seiner präferierten Arbeitsweise entschieden werden.

Eine weitere bevorzugte Weiterbildung des erfindungsgemäßen Verfahrens ist dabei, dass die Ausgabereihenfolge der belichteten Druckplatten innerhalb eines Arbeitsgangs in der geplanten Reihenfolge der Farbauszüge an der Druckmaschine oder entgegen dieser erfolgt. Gleiches wie für die Ausgabereihenfolge der Arbeitsgänge pro Druckplattenstapel gilt daher ebenfalls für die Ausgabereihenfolge der belichteten Druckplatten innerhalb eines Arbeitsgangs.

Eine weitere bevorzugte Weiterbildung des erfindungsgemäßen Verfahrens ist dabei, dass die vom Rechner gesteuerte Bildung von sortierten Druckplattenstapeln rein automatisch oder durch Vorgabe eines Bedieners unter Berücksichtigung der geplanten Druckreihenfolge und deren Datenverfügbarkeit erfolgt. Bevorzugt wird selbstverständlich eine rein automatische Bildung von sortierten Druckplattenstapeln. Diese automatische Bildung ist dabei abhängig von den entsprechenden Druckauftragsdaten, der jeweiligen Offsetdruckmaschine, und weiteren Parametern. Alternativ zur rein automatisierten Abarbeitung ist jedoch auch ein direktes Eingreifen eines Bedieners bzw. Anwenders möglich. Dies kann z.B. dann notwendig werden, wenn nicht sämtliche, zur automatischen Abarbeitung notwendigen Daten zur Verfügung stehen. Auch für den Fall, dass die automatische Abarbeitung nicht das optimalste Ergebnis zur Sortierung der Druckplatten liefert, sollte eine Eingriffsmöglichkeit eines Anwenders stets möglich bleiben.

Eine weitere bevorzugte Weiterbildung des erfindungsgemäßen Verfahrens ist dabei, dass die vom Rechner gesteuerte Ausgabe der sortierten Druckplattenstapeln auf dem mindestens einen Plattenbelichter rein automatisch oder durch Vorgabe eines Bedieners unter Berücksichtigung der geplanten Startdaten und der Verfügbarkeit des mindestens einen Plattenbelichters erfolgt. Gleiches wie für die Bildung der Plattenstapel durch den Rechner in der gewünschten Sortierung gilt auch für die Ausgabe der Platten auf dem jeweiligen Plattenbelichter.

Die Erfindung als solche sowie konstruktiv und/oder funktionell vorteilhafte Weiterbildungen der Erfindung werden nachfolgend unter Bezug auf die zugehörigen Zeichnungen anhand wenigstens eines bevorzugten Ausführungsbeispiels näher beschrieben. In den Zeichnungen sind einander entsprechende Elemente mit jeweils denselben Bezugszeichen versehen.

Die Zeichnungen zeigen:
- Figur 1: einen schematischen Aufbau des verwendeten Druckmaschinensystems
- Figur 2: eine schematische Übersicht über das erfindungsgemäße Verfahren
- Figur 3: den schematischen Ablauf zur vorsortierten Herstellung der Druckplatten

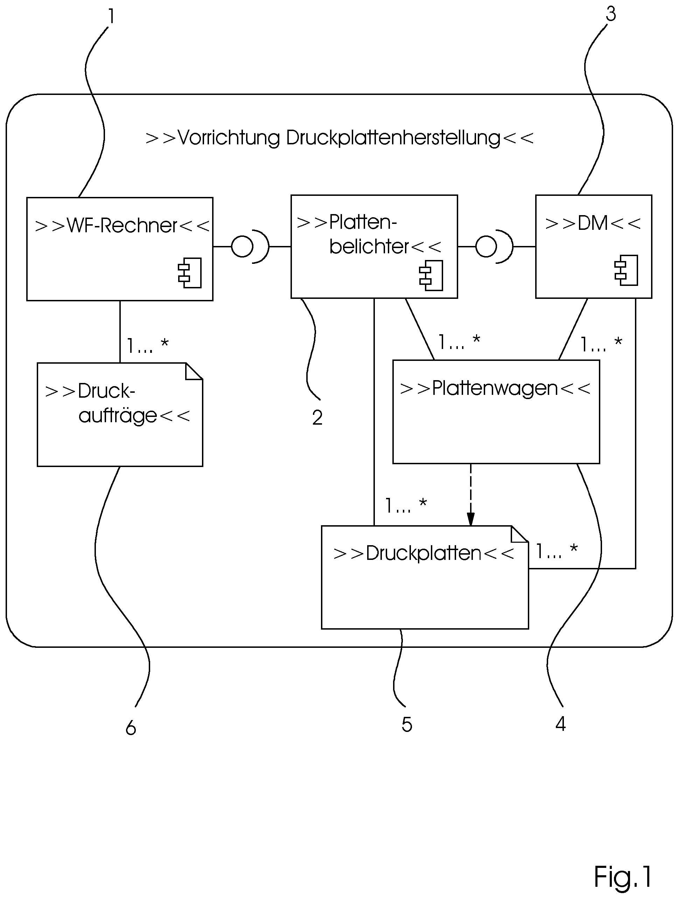

Das erfindungsgemäße Verfahren in seiner bevorzugten Ausführungsvariante wird bevorzugt auf einem Offsetdruckmaschinensystem eingesetzt, wie es beispielhaft und schematisch in Figur 1 dargestellt ist. Das System besteht neben mindestens einer Offsetdruckmaschine 3 aus mindestens einem Plattenbelichter 2, auf welchem die entsprechenden Druckplatten 5 zum Einsatz in der Offsetdruckmaschine 3 erzeugt werden. Diese erhalten wiederum die digitalen Farbauszugsdaten 8, aus welchen die einzelnen Druckplatten 5 erzeugt werden, von mindestens einem Rechner 1 der Druckvorstufe 7, in welchem die Druckauftragsdaten 6 erstellt werden. Der ganze Vorgang wird von einem rechnergestützten Workflowsystem, bzw. dessen zuständigen Komponenten 9, überwacht.

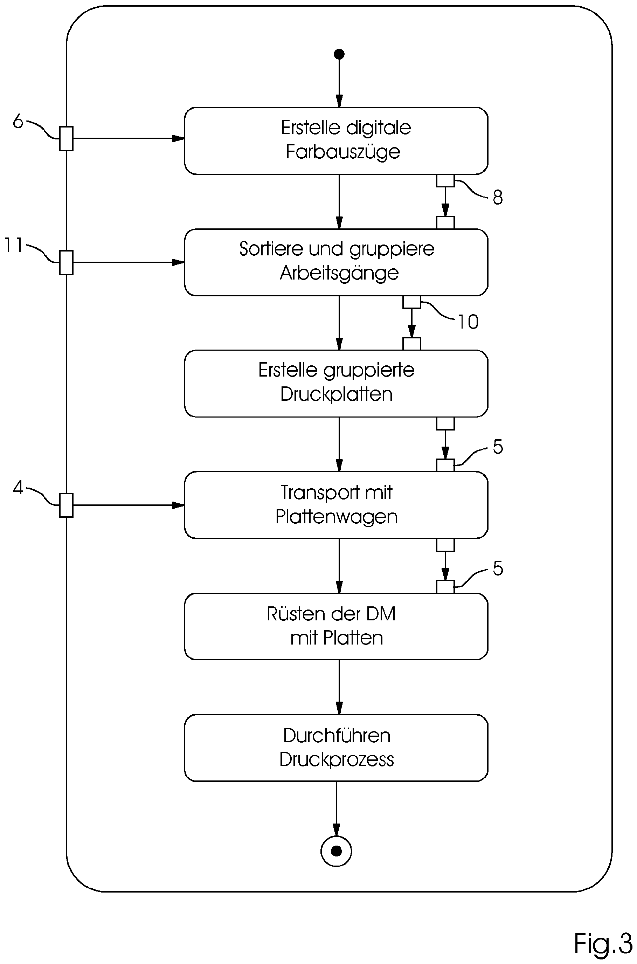

Die bevorzugte Ausführungsvariante des erfindungsgemäßen Verfahrens ist dabei schematisch bzgl. des Ablaufs in Figur 3 dargestellt. Für die Bestimmung der Ausgabereihenfolge der Druckplatten 5 wird die geplante, zu verwendende Druckmaschine 3 und die geplante Reihenfolge der Arbeitsgänge 11 herangezogen. In einem ersten Schritt werden dabei zunächst alle für die bestimmte Druckmaschine 3 geplanten Arbeitsgänge 11 nach geplantem Startdatum sortiert. Die Arbeitsgänge 11 werden in Gruppen zusammengefasst, deren Druckplatten 5 jeweils in Form eines Plattenstapels auf einem Plattenwagen 4 abgelegt werden sollen. Bei Verfügbarkeit der digitalen Daten für einen Plattenstapel werden dessen Platten 5 in der gewünschten Reihenfolge ausgegeben. Dadurch wird gewährleistet, dass die Platten 5 in der Reihenfolge auf dem Wagen 4 stehen, wie sie nach der geplanten Druckreihenfolge an der Druckmaschine 3 benötigt werden.

Je nach Ausgestaltung des Plattenwagens 4 und der Ablage kann die Ausgabereihenfolge der Arbeitsgänge 11 pro Plattenstapel in der geplanten oder umgekehrt zur geplanten Druckreihenfolge erfolgen. Auch kann nach gewünschter Entnahmereihenfolge der Platten 5 an der Druckmaschine 3 die Ausgabereihenfolge der Platten 5 innerhalb eines Arbeitsgangs 11 in der geplanten Farbreihenfolge an der Druckmaschine 3 oder entgegen dieser erfolgen.

In einer besonders bevorzugten Ausführungsvariante des erfindungsgemäßen Verfahrens wird die Bildung von Plattenstapeln automatisch nach konfigurierbaren Regeln, die die Bedürfnisse der Druckerei abbilden und unter Berücksichtigung der geplanten Druckreihenfolge und deren Datenverfügbarkeit erfolgen. Jedoch ist auch eine manuell Bildung von Plattenstapeln durch einen Bediener, der die Liste der Druckarbeitsgänge 11 in der geplanten Reihenfolge und deren Datenverfügbarkeit sieht, möglich.

Die bevorzugte Ausführungsform sieht ebenfalls vor, dass die Ausgabe der Plattenstapel auf einem oder mehreren Belichtern 2 automatisch nach konfigurierbaren Regeln erfolgt, in denen die geplanten Drucktermine und die Verfügbarkeit der Plattenbelichter 2 das Weiterleiten der Plattenstapel zu einem Belichter 2 steuern. Auch hier ist jedoch eine manuelle Ausgabe der Plattenstapel auf einem oder mehreren Belichtern 2 durch einen Bediener, der die auszugebenden Plattenstapel mit ihrem geplanten Druckbeginn und die Verfügbarkeit der Plattenbelichter 2 überblickt, möglich.

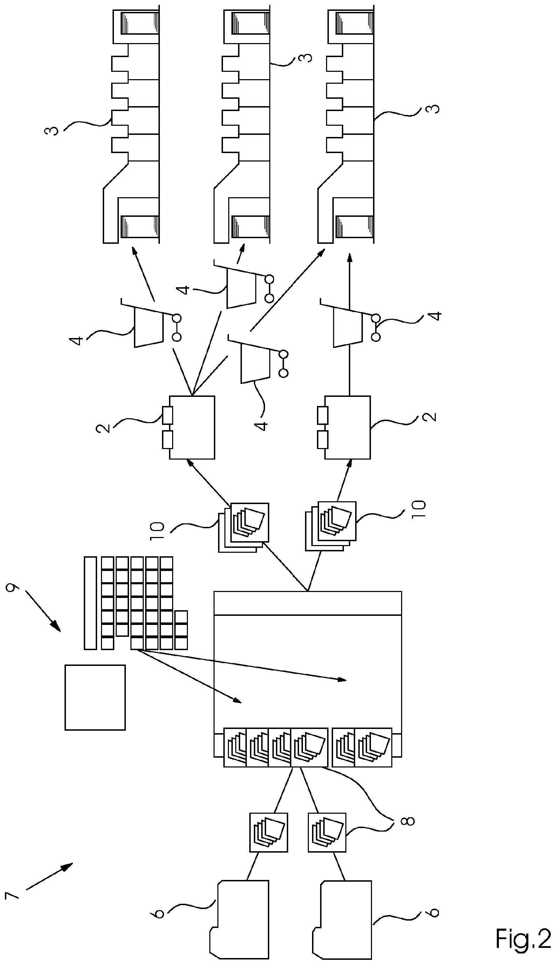

In Figur 2 ist dazu noch einmal eine schematische Übersicht über das erfindungsgemäße Verfahren abgebildet. Gut zu erkennen ist, wie in der Vorstufe 7 rechnergestützt die jeweiligen Sätze von digitalen Farbauszugsdaten 8 zur Erstellung der Druckplatten 5 aus den verschiedenen Druckaufträgen 6 erzeugt werden, und wie diese dann durch die zuständige Komponente des Workflowsystems 9 entsprechend erfindungsgemäß vom Rechner 1 gruppiert und sortiert werden. Die sortierten Sätze von Farbauszugsdaten 10 werden dann an den oder die Plattenbelichter 2 ausgegeben und von diesen mittels bestimmten, den jeweiligen Offsetdruckmaschinen 3 zugeordneten Plattenwagen 4, zu der jeweiligen Zieloffsetdruckmaschine 3 transportiert.

Die Vorteile des erfindungsgemäßen Verfahrens ggü. dem Stand der Technik sind zum Einen, dass keine unnötigen Wartezeiten an der Druckmaschine 3 durch Belichtung der Platten 5 entsprechend der Druckreihenfolge mehr erforderlich sind. Weiterhin ist kein Umsortieren von Platten 5, die in der falschen Reihenfolge auf dem Plattenwagen 4 stehen mehr notwendig. Dies bedeutet, dass es auch zu keinem Verkratzen von Druckplatten 5 beim Umsortieren bzw. Entnehmen mehr kommen kann. Zum Anderen ist nun eine auftragsübergreifende Druckplanung möglich, welche die Optimierung der Druckreihenfolge zur Rüstzeitoptimierung erlaubt.

### Bezugszeichenliste

1 Rechner
2 Plattenbelichter
3 Offset-Druckmaschine
4 Plattenwagen
5 Druckplatten
6 Druckauftrag
7 Vorstufe
8 Sätze von digitalen Farbauszugsdaten
9 für Plattenmanagement zuständige Komponente des Workflowsystem
10 Sätze von sortierten, digitalen Farbauszugsdaten
11 Arbeitsgänge an der Offset-Druckmaschine

## Patentansprüche

1. Verfahren zur Herstellung von belichteten Druckplatten (5) für einen Druckprozess von Offsetdruckmaschinen (3) durch einen Rechner (1) eines Workflowsystems (9), wobei der Rechner (1) in der Druckvorstufe (7) Druckauftragsdaten (6) sammelt, daraus dann Sätze digitaler Farbauszugsdaten (8) zur Erstellung der Druckplatten (5) generiert, diese an mindestens einen Plattenbelichter (2) schickt, wo die betreffenden, belichteten Druckplatten (5) erzeugt werden, von wo sie dann als Druckplattenstapel mittels Plattenwagen (4) zu ihren Offsetdruckmaschinen (3) transportiert werden und wobei die Offsetdruckmaschinen (3) dann mit den erzeugten belichteten Druckplatten (5) den Druckprozess durchführen, wobei der Rechner (1) die Sätze digitaler Farbauszugsdaten (8) zur Erstellung der belichteten Druckplatten (5) in einer Reihenfolge abhängig von der geplanten Reihenfolge notwendiger Arbeitsgänge (11) an den Offsetdruckmaschinen (3) sortiert, wodurch die Druckplattenstapel der daraus erzeugten, belichteten Druckplatten (5) dann auf den Plattenwagen (4) in der jeweils benötigten Reihenfolge zu den Offsetdruckmaschinen (3) transportiert werden.

2. Verfahren nach Anspruch 1,
**dadurch gekennzeichnet,**
**dass** die notwendigen Arbeitsgänge (11) an den Offsetdruckmaschinen (3) den Rüstvorgängen der belichteten Druckplatten (5) der jeweiligen Farbauszüge (10) an den Offsetdruckmaschinen (3), sowie dem Einrichten der Offsetdruckmaschinen (3) für den Fortdruck und dem Fortdruck zur Abarbeitung des Druckprozesses entsprechen.

3. Verfahren nach einem der vorherigen Ansprüche,
**dadurch gekennzeichnet,**
**dass** die notwendigen Arbeitsgänge (11) vom Rechner (1) jeweils für eine bestimmte Offsetdruckmaschine (3) vom Rechner (1) nach ihrem geplanten Startdatum sortiert werden.

4. Verfahren nach Anspruch 3,
**dadurch gekennzeichnet,**
**dass** die sortierten Arbeitsgänge (11) durch den Rechner (1) in Gruppen, deren belichtete Druckplatten (5) jeweils auf einem Plattenwagen (4) transportiert werden sollen, zusammengefasst werden.

5. Verfahren nach einem der vorherigen Ansprüche,
**dadurch gekennzeichnet,**
**dass** die Ausgabereihenfolge der Arbeitsgänge (11) pro Druckplattenstapel in der geplanten oder umgekehrt zur geplanten Druckreihenfolge erfolgt.

6. Verfahren nach einem der vorherigen Ansprüche,
**dadurch gekennzeichnet,**
**dass** die Ausgabereihenfolge der belichteten Druckplatten (5) innerhalb eines Arbeitsgangs (11) in der geplanten Reihenfolge der Farbauszüge (10) an der bestimmten Offsetdruckmaschine (3) oder entgegen dieser erfolgt.

7. Verfahren nach einem der vorherigen Ansprüche,
**dadurch gekennzeichnet,**
**dass** die vom Rechner (1) gesteuerte Bildung von sortierten Druckplattenstapeln rein automatisch oder durch Vorgabe eines Bedieners unter Berücksichtigung der geplanten Druckreihenfolge und deren Datenverfügbarkeit erfolgt.

8. Verfahren nach Anspruch 7,
**dadurch gekennzeichnet,**
**dass** die vom Rechner (1) gesteuerte Ausgabe der sortierten Druckplattenstapeln auf dem mindestens einen Plattenbelichter (2) rein automatisch oder durch Vorgabe eines Bedieners unter Berücksichtigung der geplanten Startdaten und der Verfügbarkeit des mindestens einen Plattenbelichters (2) erfolgt.

## Claims

1. Method of manufacturing exposed printing plates (5) for a printing operation on offset printing presses (3) by means of a computer (1) of a workflow system (9), wherein the computer (1) collects print job data (6) at the pre-press stage (7), generates sets of digital color separation data (8) for creating the printing plates (5), and sends the data to at least one platesetter (2), where the related exposed printing plates (5) are created and from where the printing plates (5) are transported to their offset printing presses (3) as printing plate stacks on a plate cart (4), wherein the offset printing presses (3) then carry out the printing operation using the generated exposed printing plates (5), wherein to create the exposed printing plates (5), the computer (1) sorts the sets of digital color separation data (8) in an order dependent on the planned order of required process steps (11) at the offset printing presses (3), causing the printing plate stacks of the exposed printing plates (5) created therefrom to be transported to the offset printing presses (3) in the respective required order on the plate cart (4).

2. Method according to claim 1,
**characterized**
**in that** the required process steps (11) at the offset printing presses (3) correspond to the set-up operations of the exposed printing plates (5) of the respective color separations (10) at the offset printing presses (3) as well as to the set-up of the offset printing presses (3) for production printing and to production printing to complete the printing operation.

3. Method according to any one of the preceding claims,
**characterized**
**in that** the computer (1) sorts the required process steps (11) for a specific offset printing press (3) in accordance with their planned starting dates.

4. Method according to claim 3,
**characterized**
**in that** the computer (1) combines the sorted process steps (11) into groups whose respective exposed printing plates (5) are to be transported on one plate cart (4).

5. Method according to any one of the preceding claims,
**characterized**
**in that** the output order of the process steps (11) per printing plate stack occurs in the planned order or in the reverse planned order.

6. Method according to any one of the preceding claims,
**characterized**
**in that** the output order of the exposed printing plates (5) within a process step (11) occurs in the planned order of the color separations (10) at the specific offset printing press (3) or in the reverse order.

7. Method according to any one of the preceding claims,
**characterized**
**in that** the computer (1)-controlled formation of sorted printing plate stacks occurs in a purely automatic way or by an operator's input factoring in the planned printing order and the availability of the data thereof.

8. Method according to claim 7,
**characterized**
**in that** the computer (1)-controlled output of the sorted printing plate stacks on the at least one platesetter (2) occurs in a purely automatic way or by an operator's input factoring in the planned starting dates and the availability of the at least one platesetter (2).

## Revendications

1. Procédé de fabrication de plaques d'impression (5) insolées pour un processus d'impression de machines à imprimer offset (3) au moyen d'un ordinateur (1) d'un système de workflow (9), pour lequel l'ordinateur (1) collecte des données de travail d'impression (6) dans la phase de prépresse (7), puis génère à partir de celles-ci des jeux de données numériques de sélection chromatique (8) pour la fabrication des plaques d'impression (5), les envoie à une unité d'insolation de plaques (2) minimum, où les plaques d'impression (5) insolées correspondantes sont produites, d'où elles sont ensuite transportées sous forme de pile de plaques d'impression au moyen de chariots porte-plaques (4) vers leurs machines à imprimer offset (3) et pour lequel les machines à imprimer offset (3) effectuent ensuite le processus d'impression avec les plaques d'impression insolées produites (5), pour lequel l'ordinateur (1) trie les jeux de données numériques de sélection chromatique (8) pour la réalisation des plaques d'impression insolées (5) dans un ordre dépendant de l'ordre prévu des opérations nécessaires (11) sur les machines à imprimer offset (3), les piles de plaques d'impression insolées (5) produites à partir de celles-ci étant ensuite transportées sur les chariots de plaques (4) vers les machines à imprimer offset (3) dans l'ordre requis respectif.

2. Procédé selon la revendication 1,
**caractérisé en ce**
**que** les opérations nécessaires (11) sur les machines à imprimer offset (3) correspondent aux opérations de mise en route des plaques d'impression insolées (5) des sélections chromatiques respectives (10) sur les machines d'impression offset (3), ainsi qu'à la mise en route des machines à imprimer offset (3) pour la production et la production en vue du traitement du processus d'impression.

3. Procédé selon l'une des revendications précédentes,
**caractérisé en ce**
**que** les opérations nécessaires (1 1) sont triées par l'ordinateur (1) dans chaque cas pour une machine à imprimer offset spécifique (3) en fonction de sa date de démarrage prévue.

4. Procédé selon la revendication 3,
**caractérisé en ce**
**que** les opérations triées (11) sont regroupées par l'ordinateur (1) pour former des groupes dont les plaques d'impression insolées (5) doivent être respectivement transportées sur un chariot porte-plaques (4).

5. Procédé selon l'une des revendications précédentes,
**caractérisé en ce**
**que** l'ordre de sortie des opérations (11) par pile de plaques d'impression s'effectue dans l'ordre d'impression prévu ou à l'inverse de l'ordre prévu.

6. Procédé selon l'une des revendications précédentes,
**caractérisé en ce**
**que** l'ordre de sortie des plaques d'impression insolées (5) dans une opération (11) a lieu dans l'ordre prévu des sélections chromatiques (10) sur la machine à imprimer offset définie (3) ou à l'inverse de l'ordre prévu.

7. Procédé selon l'une des revendications précédentes,
**caractérisé en ce**
**que** la formation de piles de plaques d'impression triées commandée par l'ordinateur (1) s'effectue entièrement automatiquement ou sur demande d'un opérateur, en tenant compte de l'ordre d'impression prévu et de la disponibilité des données considérée.

8. Procédé selon la revendication 7,
**caractérisé en ce**
**que** la sortie des piles de plaques d'impression triées sur l'unité d'insolation de plaques (2) minimum commandée par l'ordinateur (1) est effectuée entièrement automatiquement ou sur demande d'un opérateur, en tenant compte des données initiales prévues et de la disponibilité de l'unité d'insolation de plaques (2) minimum.
